# EUROPEAN PATENT APPLICATION

(11) **EP 4 664 122 A1**
(43) Date of publication of application: **17.12.2025**
(21) Application number: 25173311.9
(22) Date of filing: 29.04.2025
(51) Int. Cl.: G01R 31/12, G01R 31/14, H02H 1/00, G06N 3/08, G08B 29/18

(54) **ARCING DETECTION METHOD AND SYSTEM**

(30) Priority: 11.06.2024 CN 202410749799
(71) Applicant: GigaDevice Semiconductor Inc., Haidian, Beijing 100094 (CN)
(72) Inventor: JIAO, Dian, Beijing, 100094 (CN); LI, Caishun, Beijing, 100094 (CN); LI, Meng, Beijing, 100094 (CN); ZHANG, Zhen, Beijing, 100094 (CN); CHEN, Xianghao, Beijing, 100094 (CN)
(74) Representative: dompatent

(57) **Abstract**

The present invention provides an arcing detection method and system, in which an AI model derives an AI score from current data and preliminarily determines whether a current signal of interest is arcing based on a comparison made between the AI score and an AI threshold. After that, it preliminarily determines whether the determination is false. These two determination steps enable more accurate arcing detection. When a false determination count becomes greater than or equal to a false determination count threshold, the AI model is retrained and dynamically updated to adapt itself to the current situation. This dispenses with the need for deployment of multiple static AI models in the system, which requires larger storage memory. The AI model can adapt itself to the current situation without needing manual commissioning of parameters, effectively reducing manpower costs. Further, this dispenses with the need for regular interrogation of environmental changes, reducing the system's task overhead.

## Description

### TECHNICAL FIELD

The present invention relates to the field of electrical fault detection, and particularly to an arcing detection method and system.

### BACKGROUND

As photovoltaic power generation, in particular distributed photovoltaic power generation develops, increasingly demanding requirements are imposed on the safety of photovoltaic power plants. In photovoltaic power generation systems, due to the presence of increasingly higher DC voltages, arcing may occur at any poorly established one of numerous electrical connections. Arcing is a phenomenon that ionization of air due to a voltage higher than its breakdown voltage produces an electric arc and makes air conductive. Arcing results in a high temperature, which may cause damage to equipment in systems, such as melting or breaking of components of equipment, or even electrical fires. As photovoltaic systems are DC systems without zero crossing, once a fire starts due to an electric arc, it will be difficult to extinguish and may cause extensive personal injury, casualties and property damage. Therefore, arcing detection is of great significance.

However, the existing arcing detection techniques are insufficiently accurate, can be used in only a limited range of applications and require a complex commissioning and deployment process.

### SUMMARY

It is an objective of the present invention to provide an arcing detection method and system, which overcomes the problems of insufficient accuracy, a limited range of applications and complex commissioning and deployment associated with the conventional arcing detection techniques.

To this end, the present invention provides an arcing detection method including:
step S1, sampling a current signal of interest a plurality of times within a sampling period, obtaining current data;
step S2, deriving an AI score by an AI model from the current data, which characterizes a probability of arcing of the current signal of interest;
step S3, determining whether the current signal of interest is arcing based on a comparison between the AI score and an AI threshold;
step S4, determining whether the determination made in step S3 is a false determination and, if so, incrementing a false determination count by one;
step S5, comparing the false determination count with a false determination count threshold and, if the false determination count is greater than or equal to the false determination count threshold, retraining the AI model and clearing the false determination count.

Optionally, if the false determination count is less than the false determination count threshold, the AI threshold may be increased by a preset value, and the method may return to step S1.

Optionally, a variance of the current data may be derived and used as a basis for determining whether the determination made in step S3 is a false determination.

Optionally, when the current signal of interest is a current less than a threshold, the variance may be used as a basis for determining whether the determination made in step S3 is a false determination.

Optionally, the current data may be subjected to time-domain analysis and/or frequency-domain analysis for determining time-domain and/or frequency-domain characteristics thereof, which are used as a basis for determining whether the determination made in step S3 is a false determination.

Optionally, if it is determined that the determination made in step S3 is not a false determination, a power supply system which produces the current signal of interest may be shut down for troubleshooting.

Optionally, current data and associated AI score values since a previous clearance of the false determination count may be at least partially retrieved and used to retrain the AI model.

The present invention also provides an arcing detection system including a sampling module and a processing module signal-connected to the sampling module,
the sampling module configured to sample a current signal of interest a plurality of times within a sampling period, thereby obtaining current data,
the processing module provided with an AI model, which derives, from the current data, an AI score characterizing a probability of arcing of the current signal of interest,
the processing module configured to determine whether the current signal of interest is arcing based on a comparison between the AI score and an AI threshold,
the processing module also configured to determine whether the determination is a false determination and, if so, increment a false determination count by one,
the processing module also configured to compare the false determination count with a false determination count threshold and, if the false determination count is greater than or equal to the false determination count threshold, retrain the AI model and clear the false determination count.

Optionally, the processing module may have internal memory storing parameters of the AI model, wherein after the AI model is retrained, the parameters stored in the internal memory are updated.

Optionally, the processing module may further include an interactive interface signal-connected to an external interactive device, wherein at least one of the AI threshold, the false determination count threshold and the preset value is configured by a signal from the external interactive device transmitted through the interactive interface.

Optionally, the arcing detection system may further include an analog-to-digital conversion (ADC) module signal-connected to the sampling module and the processing module, wherein the sampling module transmits the current data to the ADC module, which then performs ADC on the current data and transmits it to the processing module.

Optionally, the sampling module may further include a plurality of sampling channels, each of which includes a mutual inductance coil, an amplifier circuit and a filter circuit.

Optionally, the mutual inductance coil may be configured to receive the current signal of interest from an input port of the sampling module, the amplifier circuit configured to amplify the current signal of interest, and the filter circuit configured to carry out hardware filtering on the amplified current signal output from the amplifier circuit to remove noise within a specified frequency range.

Optionally, in the arcing detection system, if the false determination count is less than the false determination count threshold, the processing module is further configured to increase the AI threshold by a preset value.

Optionally, in the arcing detection system, current data and associated AI score values since a previous clearance of the false determination count are at least partially retrieved and used to retrain the AI model.

The arcing detection method and system of the present invention have the following benefits:
1) An AI model derives an AI score from current data and preliminarily determines whether a current signal of interest is arcing based on a comparison made between the AI score and an AI threshold. After that, it further preliminarily determines whether the determination is false. These two determination steps enable more accurate arcing detection and reduce the risk of missing judgment or misjudgment.
2) When a false determination count becomes greater than or equal to a false determination count threshold, the AI model is retrained and dynamically updated to adapt itself to the current situation. This dispenses with the need for deployment of multiple static AI models in the system, which requires larger storage memory. The present invention can evaluate the detection ability of a deployed AI model, train, retrain and create an arcing detection AI model with massive data, ensure accurate identification of electric arc characteristics in various scenarios and reduce the risk of missing or incorrect warnings.
3) The AI model can adapt itself to the current situation in various power supply systems and environments without needing manual commissioning of parameters, effectively reducing manpower costs. Further, this dispenses with the need for regular interrogation of environmental changes, reducing the system's task overhead.
4) Any identified false determination can be cumulatively counted, and the AI threshold can be accordingly adjusted in an adaptive manner to loosen the criterion for the preliminary determination step to avoid further false determinations.

### BRIEF DESCRIPTION OF THE DRAWINGS

Fig. 1 shows a flowchart of an arcing detection method according to an embodiment of the present invention.
Fig. 2 shows a more detailed flowchart of the arcing detection method according to an embodiment of the present invention.
Fig. 3 is a structural block diagram of an arcing detection system according to an embodiment of the present invention.
Fig. 4 is a structural block diagram of another arcing detection system according to an embodiment of the present invention.

In these figures, 10 denotes a processing module; 20, a sampling module; 30, an LDO module; 40, a communication module; 50, an ADC module; 201, a mutual inductance coil; 202, an amplifier circuit; and 203, a filter circuit.

### DETAILED DESCRIPTION

Specific embodiments of the present invention are described in greater detail below with reference to the accompanying drawings. From the following description, advantages and features of the present invention will be more apparent. Note that the figures are provided in a very simplified form not necessarily drawn to exact scale for the only purpose of helping explain the disclosed embodiments in a more convenient and clearer way.

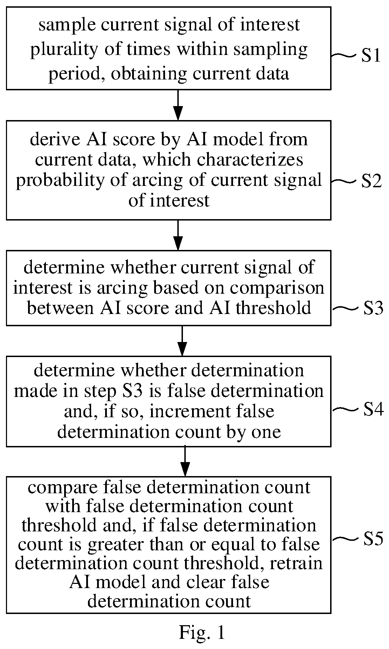

Fig. 1 shows a flowchart of an arcing detection method according to an embodiment of the present invention. As shown in Fig. 1, the arcing detection method includes the steps of:
S1) sampling a current signal of interest multiple times within a sampling period, obtaining current data;
S2) deriving an AI score by an AI model from the current data, which characterizes a probability of arcing of the current signal of interest;
S3) determining whether the current signal of interest is arcing based on a comparison between the AI score and an AI threshold;
S4) determining whether the determination made in step S3 is false and, if so, incrementing a false determination count by one; and
S5) comparing the false determination count with a false determination count threshold and, if the false determination count is greater than or equal to the false determination count threshold, retraining the AI model and clearing the false determination count.

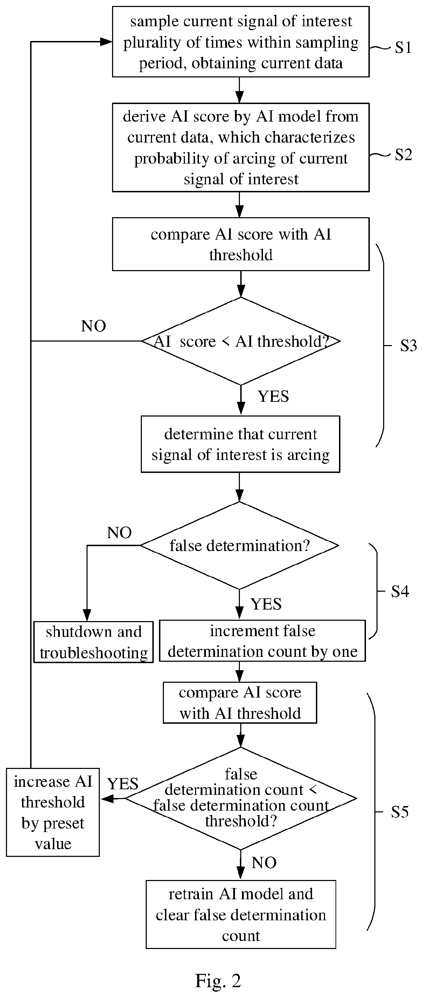

Fig. 2 is a more detailed flowchart of the arcing detection method according to an embodiment of the present invention. The arcing detection method of the present invention will be described in detail below with reference to Fig. 2.

As shown in Fig. 2, in step S1, a current signal of interest is obtained, which may be a real-time current signal at a DC side of a photovoltaic power generation system, for example. However, the invention is not so limited, because the current signal of interest may also be a real-time current signal from another power supply system in need of arcing detection, such as an automobile power distribution system or the like.

Multiple current values are obtained by sampling the current signal of interest multiple times within a sampling period and combined into current data. As used herein, the term "multiple times" means "at least two times". Accordingly, the current data contains at least two current values. However, it will be understood that, in practical applications, the number of times the signal is sampled depends on a sampling frequency of the sampling module used, and the higher the sampling frequency is, the more times the signal is sampled and the more current values the current data contains.

In step S2, an AI model is provided, which may have been trained with historical current data according to a machine learning method. The current data is input to the AI model, which may then automatically output an AI score based on the current data.

In some embodiments, the AI model may be a CNN neural network model, an LSTM neural network model or another known AI model, further description of which is omitted herein.

The AI score characterizes a probability of arcing of the current signal of interest. In one embodiment, a higher value of the AI score indicates a lower probability of arcing of the current signal of interest. On the contrary, a lower value of the AI score indicates a higher probability of arcing of the current signal of interest. Of course, the AI model is not limited to such an algorithm. For example, an opposite algorithm may also be possible, i.e., a higher value of the AI score indicates a higher probability of arcing of the current signal of interest; and a lower value of the AI score indicates a lower probability of arcing of the current signal of interest. In this embodiment, the AI score from the AI model is in the range of 0-65536. Thus, the closer the AI score is to 65536, the lower a probability of arcing of the current signal of interest that it indicates; and the closer the AI score is to 0, the higher a probability of arcing of the current signal of interest that it indicates. Each value of the AI score may correspond to a respective specific value of the probability of arcing of the current signal of interest. For example, when the AI score is 2000, it may indicate a probability of 97% of the current signal of interest being arcing. As another example, when the AI score is 12000, it may indicate a probability of 81.6% of the current signal of interest being arcing. As yet another example, when the AI score is 32000, it may indicate a probability of 51% of the current signal of interest being arcing.

In step S3, the AI score is compared with an AI threshold, producing a result of comparison indicating which of the AI score and the AI threshold is greater or smaller. If the AI score is lower than the AI threshold, it is indicated that the current signal of interest is associated with such a high probability of arcing that a determination can be made that it is arcing. If the AI score is higher than the AI threshold, it is indicated that the current signal of interest it is less likely to be arcing and that a determination can be made that it is not arcing. For example, an initial value of the AI threshold may be set to 2000. Accordingly, if the AI score is lower than 2000, it may be indicated that the current signal of interest is associated with a probability of arcing greater than 97%, and a determination may be made that the current signal of interest is arcing. If the AI score is greater than or equal to 2000, it may be indicated that the current signal of interest is associated with a probability of arcing lower than or equal to 97%, and a determination may be made that the current signal of interest is not in an arcing condition.

It will be understood that the AI threshold serves as a basis for making the determination in step S3 and determines a critical probability above which the current signal of interest will be determined to be arcing. Therefore, it is crucial to determining whether the current signal of interest is arcing. The initial value of the AI threshold may be usually an empirical value, which may be, but is not limited to being, 2000, and other values than 2000 are also possible.

Further, if it is determined that the current signal of interest is not arcing, the method may return to step S1 to progress to arcing detection for the next sampling period.

It will be understood that as the AI model is trained with historical current data, it is static and lacks adaptiveness. Therefore, a change in equipment type, equipment parameters, cable length, current magnitude, system environment, etc. may lead to a false determination made in step S3.

In view of this, when the current signal of interest is determined to be arcing, step S4 is performed to determine whether the determination made in step S3 is false. If it is determined that the determination made in step S3 is not a false determination, then a final determination may be made that the current signal of interest is arcing. In response, the power supply system that generates the current signal of interest (in this embodiment, it may be the aforementioned photovoltaic power generation system) may be shut down for troubleshooting. If the determination made in step S3 is determined to be false, then a false determination count is incremented by 1. In this way, false determinations can be counted cumulatively.

In this embodiment, the current signal of interest is a small current (i.e., a current less than a threshold), for example, of 0-24 A. In this case, if the current signal of interest is arcing, the current data will have a variance generally of hundreds to thousands. On the contrary, if the current signal of interest is not in an arcing condition, the variance will be generally within 100. Therefore, the variance of the current data can vary by orders of magnitude between presence and absence of arcing of the current signal of interest. Accordingly, the variance of the current data can be utilized to determine whether the determination from step S3 is false or not.

Specifically, the variance of the current data may be derived and compared with a variance threshold. If the variance of the current data is less than the variance threshold, it is indicated that it is unreasonable to determine that the current signal of interest is arcing, and the determination from step S3 may be determined to be false. If the variance is greater than or equal to the variance threshold, it is indicated that it is reasonable to determine that the current signal of interest is arcing, and the determination from step S3 may be determined not to be a false determination.

It will be understood that the variance threshold may be generally an empirical value, which may be, but is not limited to being, 100, and other values than 100 are also possible.

In some embodiments, the current data may also be subjected to time-domain and/or frequency-domain analysis for determining its time-domain and/or frequency-domain characteristics which may serve as a basis for determining whether the determination made in step S3 is a false determination. Specifically, the time-domain and frequency-domain characteristics may represent energy in the time-domain and frequency-domain spectra, respectively. When the current signal of interest is arcing, it will be a large current with a large amount of energy. On the contrary, when the current signal of interest is not in an arcing condition, it will be a small current (i.e., a current less than a threshold) with a small amount of energy. Therefore, the determination made in step S3 can be determined to be false or not, based on a comparison made between the time-domain characteristic with an associated time-domain characteristic threshold and/or on a comparison made between the frequency-domain characteristic with an associated frequency-domain characteristic threshold.

It will be understood that the above methods of determining whether the determination made in step S3 is false are merely exemplary, and other known methods capable of determining whether the determination made in step S3 is false can also be suitably used.

Notably, when the current signal of interest is a large current, for example, of 24 A or more, there will be no significant difference spanning one or more orders of magnitude between presence and absence of arcing. In this case, the aforesaid time-domain and/or frequency-domain characteristics of the current signal of interest may be used as a basis for determining whether the determination made in step S3 is a false determination or not.

Next, in step S5, the false determination count is compared with a false determination count threshold. If the false determination count is less than the false determination count threshold, it is indicated that the cumulative false determination count is still within a permissible range. Accordingly, the AI threshold may be increased by a preset value to loosen the determination criterion in step S3, and the method may loop back to step S1. For example, the preset value may be 10000, and the initial AI threshold value may be 2000. If a false determination is made for a first sampling period, the AI threshold may be increased by 10000 to 12000 for a second sampling period. If no false determination is made neither for the second sampling period nor for a third sampling period, the AI threshold may remain 12000. If another false determination is made for a fourth sampling period, the AI threshold may be again increased by 10000 to 22000 for a fifth sampling period.

It will be understood that although the preset value has been described as 10000, it is merely exemplary, and other values are also possible.

In this embodiment, the AI score is first compared to the AI threshold, and the comparison is used to preliminarily determine whether the current signal of interest is arcing. After that, a further determination is made as to whether the preliminary determination is a false determination. These two determination steps enable more accurate arcing detection and reduce the risk of missing judgment or misjudgment. Moreover, any identified false determination can be counted cumulatively, and the AI threshold can be accordingly adjusted in an adaptive manner to loosen the criterion for the preliminary determination step to avoid further false determinations.

Further, when the false determination count is greater than or equal to the false determination count threshold, it is indicated that the cumulative false determination count has exceeded the permissible range and that it is no longer possible for the AI model to accurately determine whether a current signal of interest is arcing. When this happens, the AI model is retrained, and the false determination count is cleared.

Specifically, the current data and associated AI score values since a previous clearance of the false determination count may be at least partially retrieved and used as a basis for retraining the AI model and for updating its parameters. For example, in case of the AI model being implemented as a CNN neural network model, its parameters may be in the form of hexadecimal arrays containing parameters of all convolutional and fully-connected layers in the AI model.

Notably, the false determination count threshold may be set taking into account the preset value. For example, when the AI score is greater than 30000, it is indicated that the current signal of interest is associated with a very low probability of arcing (approximately 50%). Assuming that the initial AI threshold value is 2000 and the preset value is 10000, if the false determination count is set to 3, then even after the AI threshold is increased twice, it will be 22000, still below 30000. Of course, the above listed AI threshold, preset value and false determination count threshold values are merely exemplary and intended to illustrate the present embodiment, and are not intended to be limiting.

As can be seen above, according to this embodiment, when the false determination count becomes greater than or equal to the false determination count threshold, the AI model can be retrained and dynamically updated to adapt itself to the current situation.

This dispenses with the need for deployment of multiple static AI models in the system, which requires larger storage memory. In addition, the present invention can evaluate the detection ability of a deployed AI model, train, retrain and create an arcing detection AI model with massive data, ensure accurate identification of electric arc characteristics in various scenarios and reduce the risk of missing or incorrect warnings. The AI model can adapt itself to the current situation in various power supply systems and environments without needing manual commissioning of parameters, effectively reducing manpower costs. Further, this dispenses with the need for regular interrogation of environmental changes, reducing the system's task overhead.

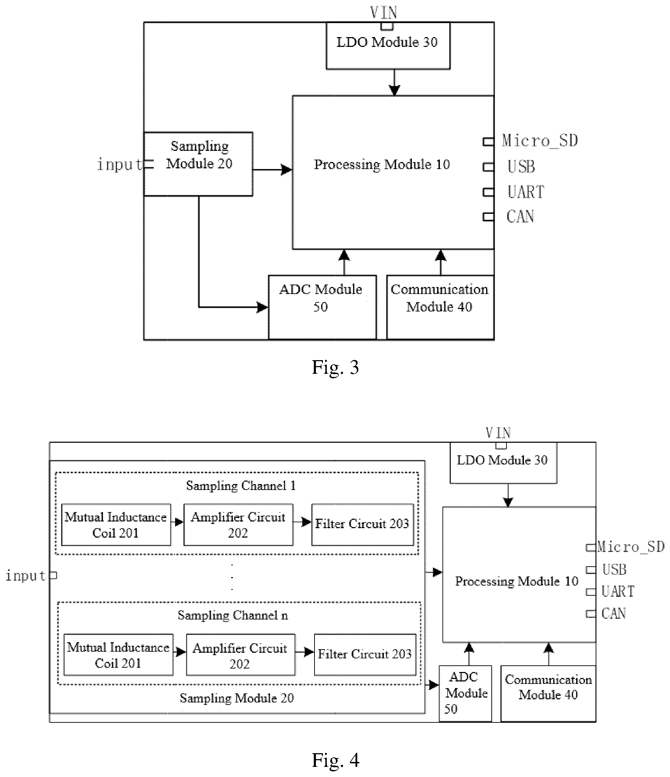

On the basis of the above, embodiments of the present invention also provide an arcing detection system which can be used to implement the arcing detection method as discussed above. Fig. 3 is a structural block diagram of an arcing detection system according to an embodiment of the present invention. In this embodiment, the arcing detection system is integrated on a chip. However, the present invention is not so limited, as the arcing detection system may also be provided on a conventional circuit board.

As shown in Fig. 3, the arcing detection system includes a sampling module 20 and a processing module 10. The sampling module 20 is signal-connected to the processing module 10.

Specifically, the sampling module 20 has an input port Input for receiving a current signal of interest. The sampling module 20 has at least one sampling channel, with which the sampling module can sample the received current signal of interest multiple times within a sampling period and thereby obtain current data. Each sampling channel may have a sampling resolution of 4K, and in this embodiment, a single sampling channel is included to sample the current signal of interest to obtain 4096 data points within each sampling period. The data points are then combined into current data, which is then transmitted to the processing module 10. For example, according to the present invention, the sampling module 20 may support arcing detection using up to 12 sampling channels at a sampling rate of 500K. Additionally, an AI model in the processing module 10 may be capable of real-time AI reasoning. Each reasoning cycle may last for only several milliseconds (e.g., ≤0.6 ms), enabling immediate response to a DC arcing event. However, the present invention is not so limited, because real-time sampling of 1024 and 2048 data points may also be supported, depending on the communication bit width and sampling rate.

The processing module 10 embodies an AI model, which derives an AI score based on the current data. The AI score characterizes a probability of arcing of the current signal of interest. The processing module 10 further determines whether the current signal of interest is arcing based on a comparison between the AI score and an AI threshold. Specifically, if the AI score is lower than the AI threshold, it may be determined that the current signal of interest is arcing. The processing module 10 further determines whether the determination is false and, if so, increments a false determination count by one. The processing module further compares the false determination count with a false determination count threshold and, if the false determination count is less than the false determination count threshold, increases the AI threshold by a preset value. Otherwise, if the false determination count is greater than or equal to the false determination count threshold, it retrains the AI model and clears the false determination count.

With continued reference to Fig. 3, according to an embodiment of the present invention, the processing module 10 may be a microprocessor, the microprocessor has internal memory (e.g., flash, RAM, etc.) storing thereon parameters of the AI model in the processing module 10. When powered on, the processing module 10 may load the parameters from the internal memory to create the AI model. The AI model may be retrained with new parameters, which may be then stored at corresponding locations in the internal memory, thus updating the parameters previous stored in the internal memory. After the processing module 10 is powered on again, the updated parameters may be loaded from the internal memory to update the AI model. In this way, only the parameters of a single AI model are stored in the internal memory, resulting in memory space savings. For example, when the AI model in the processing module 10 is implemented as a CNN neural network model, its parameters may be parameters of the model's all convolutional and fully-connected layers.

As a matter of course, other information may also be stored in the internal memory, such as the AI threshold, the false determination count threshold, the preset value, etc.

Further, the processing module 10 has a number of interfaces such as Micro_SD, interactive (USB), UART, CAN and other interfaces. With the Micro_SD interface, an SD card can be connected to the processing module 10 to allow storage of data in the SD card, such as the current data received by the processing module 10, the AI score output from the AI model, etc. Such data can be retrieved when needed, without occupying any space of the internal memory. With the USB, UART or other interface, the processing module 10 can communicate with an external interactive device, which may interact with the processing module 10, in order to configure at least one of the AI threshold, the false determination count threshold and the preset value. With the UART or CAN interfaces, the processing module 10 can communicate with other types of external devices. The external interactive device may be a host, an LCD touch screen, another human-machine interaction device, etc.

Notably, the processing module 10 is not limited to including only the Micro_SD, USB, UART and CAN interfaces and may include other possible interfaces, further description of which is, however, omitted herein.

In this embodiment, the arcing detection system further includes a communication module 40, which may be a wireless communication module, such as WiFi, 3G, 4G, 5G or cellular, or a wired communication module. The communication module 40 is signal-connected to the processing module 10, the processing module 10 is configured to upload data from the SD card, such as the current data and the AI score, through the communication module 40 to a server (not shown) for updating of the AI model. After the AI model is trained, the server may send parameters of the AI model to the processing module 10 through the communication module 40. In one embodiment, the communication module 40 and the processing module 10 may be provided in a single chip, such as micro controller unit (MCU) or system-on-chip SoC), so as to be independent of each other. In other embodiments, the communication module 40 and the processing module 10 may be provided as discrete components, such as two separate SoC chips.

In this embodiment, the arcing detection system further includes an LDO module 30, the LDO module 30 is provided with a power supply interface VIN, the power supply interface VIN is connected to a DC power supply and receives a DC voltage (e.g., 7-16 V) therefrom. The LDO module 30 can provide the processing module 10 with a stable power supply voltage (e.g., 3.3 V or 2.5 V).

The arcing detection system further includes an analog-to-digital conversion (ADC) module 50. In one embodiment, the ADC module 50 and the processing module 10 may be provided in a single chip, such as MCU or SoC, so as to be independent of each other. In other embodiments, the ADC module 50 and the processing module 10 may be provided as discrete components, such as two separate chips. The ADC module 50 is signal-connected to the sampling module 20 and the processing module 10. The current data from the sampling module 20 may be first processed by the ADC module 50, and the resulting digital signals may be provided to the processing module 10. The processing module 10 may itself include an internal ADC element, which, however, may fail to provide good ADC accuracy. The added external ADC module 50 may be much more accurate, and processing the current data with this ADC module 50 can additionally increase detection accuracy.

In some embodiments, the ADC module 50 may be omitted.

Notably, the arcing detection system may further include other circuit modules not mentioned herein, such as peripheral amplifier circuits and filter circuits, further description of which is, however, omitted herein.

Fig. 4 is a structural block diagram of another arcing detection system according to an embodiment of the present invention. Reference is now made to Fig. 4, in which the modules also included in the embodiment of Fig. 3 are given the same reference numerals, and further description thereof is omitted. The embodiment of Fig. 4 differs from that of Fig. 3 in that the sampling module 20 includes a plurality (n in this embodiment, which is greater than 1) of sampling channels, each sampling channel includes a mutual inductance coil 201, an amplifier circuit 202 and a filter circuit 203. The mutual inductance coils 201 receive a current to be sampled from the input port Input, and the amplifier circuits 202 then amplify the current. In addition, as signals fed for arcing detection tend to be noisy, the filter circuits 203 are included to carry out hardware filtering (e.g., fourth-order or other filtering) on the current to remove noise within specified frequency ranges (e.g., by filtering out components of the current signal outside the frequency range of 30-100 KHz).

In summary, in arcing detection methods and systems according to embodiments of the present invention, an AI model derives an AI score from current data and preliminarily determines whether a current signal of interest is arcing based on a comparison made between the AI score and an AI threshold. After that, it further preliminarily determines whether the determination is false. These two determination steps enable more accurate arcing detection and reduce the risk of missing judgment or misjudgment. When a false determination count becomes greater than or equal to a false determination count threshold, the AI model is retrained and dynamically updated to adapt itself to the current situation. This dispenses with the need for deployment of multiple static AI models in the system, which requires larger storage memory. The present invention can evaluate the detection ability of a deployed AI model, train, retrain and create an arcing detection AI model with massive data, ensure accurate identification of electric arc characteristics in various scenarios and reduce the risk of missing or incorrect warnings. The AI model can adapt itself to the current situation in various power supply systems and environments without needing manual commissioning of parameters, effectively reducing manpower costs. Further, this dispenses with the need for regular interrogation of environmental changes, reducing the system's task overhead. Any identified false determination can be cumulatively counted, and the AI threshold can be accordingly adjusted in an adaptive manner to loosen the criterion for the preliminary determination step to avoid further false determinations.

It is to be noted that the embodiments disclosed herein are described in a progressive manner, with the description of each embodiment focusing on its differences from others. Cross reference can be made between the embodiments for their common or similar features. Since the system embodiments correspond to the method embodiments, they are described relatively briefly, and reference can be made to the method embodiments for more details.

It is also to be noted that while the invention has been described above with reference to preferred embodiments thereof, it is not limited to these embodiments. In light of the above teachings, any person familiar with the art may make many possible modifications and variations to the disclosed embodiments or adapt them into equivalent embodiments, without departing from the scope of the invention. Accordingly, it is intended that any and all simple variations, equivalent alternatives and modifications made to the foregoing embodiments based on the substantive disclosure of the invention without departing from the scope thereof fall within the scope.

Further, it is to be understood that, as used herein, the terms "first", "second", "third" and the like are only meant to distinguish various components, elements, steps, etc. from each other and are not intended to indicate logical or sequential orderings thereof, unless otherwise indicated or specified.

It is also to be recognized that the terminology used herein is for the purpose of describing particular embodiments only, and is not intended to limit the scope of the present invention. It must be noted that, as used herein and in the appended claims, the singular forms "a" and "an" include the plural reference unless the context clearly dictates otherwise. Thus, for example, a reference to "a step" or "a means" is a reference to one or more steps or means and may include sub-steps and sub-means. All conjunctions used are to be understood in the most inclusive sense possible. Thus, the term "or" should be understood as having the definition of a logical "or" rather than that of a logical "exclusive or" unless the context clearly necessitates otherwise. Further, implementation of the method and/or device according to the embodiments of the present invention may involve performing selected tasks manually, automatically, or a combination thereof.

## Claims

1. An arcing detection method comprising:
step S1, sampling a current signal of interest a plurality of times within a sampling period, obtaining current data;
step S2, deriving an AI score by an AI model from the current data, the AI score characterizes a probability of arcing of the current signal of interest;
step S3, determining whether the current signal of interest is arcing based on a comparison between the AI score and an AI threshold;
step S4, determining whether the determination made in step S3 is a false determination and, if so, incrementing a false determination count by one;
step S5, comparing the false determination count with a false determination count threshold and, if the false determination count is greater than or equal to the false determination count threshold, retraining the AI model and clearing the false determination count.

2. The arcing detection method of claim 1, wherein if the false determination count is less than the false determination count threshold, the AI threshold is increased by a preset value, and the arcing detection method returns to step S1.

3. The arcing detection method of claim 1 or 2, wherein a variance of the current data is derived, the variance is used as a basis for determining whether the determination made in step S3 is a false determination.

4. The arcing detection method of claim 3, wherein when the current signal of interest is a current less than a threshold, the variance is used as a basis for determining whether the determination made in step S3 is a false determination.

5. The arcing detection method of claim 1 or 2, wherein the current data is subjected to time-domain analysis and/or frequency-domain analysis for determining time-domain and/or frequency-domain characteristics of the current data, the time-domain and/or frequency-domain characteristics of the current data are used as a basis for determining whether the determination made in step S3 is a false determination.

6. The arcing detection method of claim 1, wherein if it is determined that the determination made in step S3 is not a false determination, a power supply system which produces the current signal of interest is shut down for troubleshooting.

7. The arcing detection method of claim 1, wherein current data and associated AI score values since a previous clearance of the false determination count are at least partially retrieved and used to retrain the AI model.

8. An arcing detection system comprising a sampling module (20) and a processing module (10) signal-connected to the sampling module (20),
the sampling module (20) configured to sample a current signal of interest a plurality of times within a sampling period, thereby obtaining current data,
the processing module (10) provided with an AI model, the AI model derives an AI score from the current data, the AI score characterizing a probability of arcing of the current signal of interest,
the processing module (10) configured to determine whether the current signal of interest is arcing based on a comparison between the AI score and an AI threshold,
the processing module (10) also configured to determine whether the determination is a false determination and, if so, increment a false determination count by one,
the processing module (10) also configured to compare the false determination count with a false determination count threshold and, if the false determination count is greater than or equal to the false determination count threshold, retrain the AI model and clear the false determination count.

9. The arcing detection system of claim 8, wherein the processing module (10) has internal memory, the internal memory storing parameters of the AI model, and wherein after the AI model is retrained, the parameters stored in the internal memory are updated.

10. The arcing detection system of claim 8, wherein the processing module (10) further comprises an interactive interface, the interactive interface is signal-connected to an external interactive device, and wherein at least one of the AI threshold, the false determination count threshold and the preset value is configured by a signal from the external interactive device transmitted through the interactive interface.

11. The arcing detection system of claim 8, further comprising an analog-to-digital conversion module (50), the analog-to-digital conversion module (50) is signal-connected to the sampling module (20) and the processing module (10), wherein the sampling module (20) transmits the current data to the analog-to-digital conversion module (50), the analog-to-digital conversion module (50) then performs analog-to-digital conversion on the current data and transmits the conversed resulting to the processing module (10).

12. The arcing detection system of claim 8, wherein the sampling module (20) further comprises a plurality of sampling channels, each of which comprises a mutual inductance coil (201), an amplifier circuit (202) and a filter circuit (203).

13. The arcing detection system of claim 12, wherein the mutual inductance coil (201) is configured to receive the current signal of interest from an input port of the sampling module (20), the amplifier circuit (202) configured to amplify the current signal of interest, and the filter circuit (203) configured to carry out hardware filtering on the amplified current signal output from the amplifier circuit (202) to remove noise within a specified frequency range.

14. The arcing detection system of claim 8, wherein if the false determination count is less than the false determination count threshold, the processing module (10) is further configured to increase the AI threshold by a preset value.

15. The arcing detection system of claim 8, wherein current data and associated AI score values since a previous clearance of the false determination count are at least partially retrieved and used to retrain the AI model.
